# EUROPÄISCHE PATENTSCHRIFT

(11) **EP 1 615 341 B1**
(45) Veröffentlichungstag und Bekanntmachung des Hinweises auf die Patenterteilung: **06.06.2012**
(21) Anmeldenummer: 05012949.3
(22) Anmeldetag: 16.06.2005
(51) Int. Cl.: H03K 17/082

(54) **Ansteuerschaltung für ein Leistungshalbleiterelement und Betriebsverfahren für eine Ansteuerschaltung**
Drive circuit for a power switching semiconductor and method of driving the same
Circuit d'attaque pour un commutateur semi-conducteur de puissance et procédé de commande d'un tel commutateur

(30) Priorität: 09.07.2004 DE 102004034923
(43) Veröffentlichungstag der Anmeldung: 11.01.2006
(73) Patentinhaber: Converteam GmbH, 12277 Berlin (DE)
(72) Erfinder: Jakob, Roland, Dr.-Ing., 12524 Berlin (DE); Boni, Marco, 10627 Berlin (DE); Luban, Bernd, 12353 Berlin (DE); Lasse, Wolfgang, 12279 Berlin (DE); Junge, Günter, 13509 Berlin (DE)
(74) Vertreter: Dreiss

(56) Entgegenhaltungen:
- US-A1- 2003 042 939
- PATENT ABSTRACTS OF JAPAN Bd. 2003, Nr. 12, 5. Dezember 2003 (2003-12-05) & JP 2004 023834 A (FUJI ELECTRIC HOLDINGS CO LTD), 22. Januar 2004 (2004-01-22)
- PATENT ABSTRACTS OF JAPAN Bd. 2003, Nr. 12, 5. Dezember 2003 (2003-12-05) & JP 2004 056980 A (FUJI ELECTRIC HOLDINGS CO LTD), 19. Februar 2004 (2004-02-19)

## Beschreibung

Die vorliegende Erfindung betrifft eine Ansteuerschaltung für ein Leistungshalbleiterbauelement mit einem Steuereingang nach dem Oberbegriff des Anspruchs 1.

Darüber hinaus betrifft die vorliegende Erfindung ein Betriebsverfahren für eine Ansteuerschealtung eines Leistungshalbleiterbauelements nach dem Oberbegriff des Anspruchs 10.

Die eingangs genannte Ansteuerschaltung ist beispielsweise bei als sog. insulated gate bipolar transistors (im folgenden: IGBT) ausgebildeten Leistungshalbleiterbauelementen dazu vorgesehen, eine als Steuereingang verwendete Gate-Elektrode des IGBT mit einem Ansteuersignal zu beaufschlagen, welches den IGBT von einer ersten Betriebsart in eine zweite Betriebsart, beispielsweise von einem Sperrzustand in einen leitenden Zustand versetzt.

Besonders bei im Mittelspannungsbereich verwendeten Leistungshalbleiterbauelementen ist eine derartige Ansteuerung sehr aufwendig, da eine eigene Hilfsenergieversorgung für die Ansteuerschaltung erforderlich ist, die die elektrische Energie für das Ansteuersignal bereitstellt. Problematisch ist hierbei insbesondere auch die Isolation der Hilfsenergieversorgung gegenüber auf Mittelspannungsniveau liegenden Schaltungsteilen bzw. Bauelementen.

Das Isolationsproblem gegenüber auf Mittelspannungsniveau liegenden Bauelementen stellt sich auch bei anderen in Mittelspannungsanlagen verwendeten Einrichtungen wie z.B. bei Messgeräten, die beispielsweise elektrische Ströme und Spannungen erfassen.

Aus der EP 708 529 A2 geht eine elektrische Schaltung hervor, mit der ein Leistungsschalter angesteuert werden kann. Die Schaltung weist Fehlererkennungsblöcke auf, die dazu vorgesehen sind, einen oder mehrere vordefinierte Fehler, die bei der Steuerung oder dem Betrieb des Leistungsschalters auftreten können, zu erkennen. Diesen Fehlern sind jeweils Codes zugeordnet, wobei der Code "000" beispielsweise den Fehler "Leistungsschalter-Entsättigung" oder der Code "001" den Fehler "Leistungsschalter-Kurzschluss" kennzeichnet. Bei diesen Fehlern handelt es sich um Zustände des Leistungsschalters, die entweder eingetreten sind oder nicht eingetreten sind. Ist der Fehler eingetreten, so wird der zugehörige Code von der Schaltung an einen anderen Block übertragen. Liegt der Fehler nicht vor, so wird insoweit nichts an den genannten Block übertragen.

JP 2004-023834 beschreibt eine Gatetreiberschaltung für einen Leistungs-Halbleiterschalter, der ein kapazitiver Spannungsteiler zugeordnet ist. Der kapazitive Spannungsteiler speist einen DC/DC-Wandler, der die Gatetreiberschaltung mit einer Gleichspannung versorgt.

JP 2004-056980 beschreibt eine Gatetreiberschaltung für einen Leistungs-Halbleiterschalter, der ein ohmsch-kapazitiver Spannungsteiler zugeordnet ist.

US 2003/0042939 A1 beschreibt eine Gatetreiberschaltung für einen Leistungs-Halbleiterschalter mit einer Messvorrichtung zur Erfassung von Betriebsgrößen des Leistungs-Halbleiterschalters.

Demgemäß ist es Aufgabe der vorliegenden Erfindung, eine verbesserte Ansteuerschaltung und ein verbessertes Betriebsverfahren für eine Ansteuerschaltung anzugeben, die insbesondere den Aufwand für eine hinreichende Isolation von mit dem Mittelspannungsniveau verbundenen Vorrichtungen vermindert.

Diese Aufgabe wird durch eine Ansteuerschaltung nach dem Anspruch 1 gelöst. Die Aufgabe wird ebenfalls durch ein Betriebsverfahren nach dem Anspruch 10 gelöst.

Die erfindungsgemäße Integration der Messvorrichtung in die Ansteuerschaltung ermöglicht eine Erfassung von Betriebsgrößen des Leistungshalbleiterbauelements, ohne dass weitere separate Hilfsenergieversorgungen für die Messvorrichtung vorgesehen werden müssen, wie dies bei Ansteuerschaltungen nach dem Stand der Technik der Fall ist. Gemäß der vorliegenden Erfindung ist eine Übertragungsvorrichtung zur Übertragung insbesondere der erfassten Betriebsgrößen an eine Steuerung vorgesehen.

Eine vorteilhafte Ausgestaltung der vorliegenden Erfindung sieht vor, dass die Übertragungsvorrichtung eine Schnittschnelle zu der Steuerung aufweist. Die vorzugsweise potentialgetrennte Schnittstelle ermöglicht der Ansteuerschaltung einen Austausch von Betriebsgrößen beispielsweise mit der Steuerung, die zum Beispiel in einem aus mehreren Leistungshalbleiterbauelementen bestehenden Stromrichter eine Überwachung der Betriebsgrößen und Steuerung des stromrichters durchführt.

Eine weitere sehr vorteilhafte Ausführungsform der vorliegenden Erfindung ist dadurch gekennzeichnet, dass die Übertragungsvorrichtung eine bereits vorhandene Schnittstelle zu der Steuerung verwenden kann, wodurch ein besonders flexibler und aufwandsarmer Einsatz der erfindungsgemäßen Ansteuerschaltung ermöglicht wird.

Bei der erfindungsgemäßen Ansteuerschaltung ist die Hilfsenergieversorgung zur Energieversorgung der Messvorrichtung (en) und der Übertragungsvorrichtung vorgesehen, wodurch sich ein hinsichtlich der Isolation von Hilfsenergieversorgungen erforderlicher Aufwand reduziert, weil mehrere Einrichtungen mit derselben Hilfsenergieversorgung versorgt werden.

Gemäß einer weiteren sehr vorteilhaften Ausführungsform sind die erfassten Betriebsgrößen priorisiert übertragbar. Die Übertragung von für den Betrieb des Leistungshalbleiterbauelements weniger bedeutsamen Größen oder von Größen, die eine verhältnismäßig geringe zeitliche Änderung aufweisen, erfolgt in diesem Falle weniger häufig beziehungsweise in Zeiträumen, in denen keine wichtigen erfassten Betriebsgrößen zu Übertragen sind.

Eine weitere Variante der erfindungsgemäßen Ansteuerschaltung sieht vor, dass die erfassten Betriebsgrößen kodierbar sind und/oder kodiert übertragbar sind. Eine Kodierung wie zum Beispiel eine Entropiekodierung der erfassten Betriebsgrößen kann zur Reduktion der zu übertragenden Datenmenge eingesetzt werden oder auch zur Erhöhung einer Zuverlässigkeit der Übertragung, indem den zu übertragenden Daten redundante Information hinzugefügt wird.

Eine weitere sehr vorteilhafte Ausführungsform der erfindungsgemäßen Ansteuerschaltung sieht vor, dass bei einer Ausbildung des Leistungshalbleiterbauelements als IGBT (insulated gate bipolar transistor) eine Kollektor-Emitter-Spannung dann übertragbar ist, wenn sich der IGBT in einem vorzugsweise stationären Sperrzustand befindet, und dass ein Laststrom durch den IGBT und/oder durch eine Freilaufdiode des IBGT dann übertragbar ist, wenn sich der IGBT in einem vorzugsweise stationären Einschaltzustand befindet.

Hierdurch ist gewährleistet, dass die für den jeweiligen Betriebszustand des IGBT, d.h. für den Sperrzustand beziehungsweise den Einschaltzustand, jeweils wichtigste Betriebsgröße, nämlich die Kollektor-Emitter-Spannung beziehungsweise der Laststrom gemessenen wird. Zusätzlich kann z.B. auch die Kollektor-Emitter-Spannung im Einschaltzustand des IGBT gemessen und/oder übertragen werden sowie weitere interessierende Betriebsgrößen. Anhand derartiger Betriebsgrößen können entstehende Fehler erkannt werden, bevor ein Schaden eintritt.

Obwohl sich die weitere Beschreibung vorwiegend auf ein als IGBT ausgebildetes Leistungshalbleiterbauelement bezieht, ist die erfindungsgemäße Ansteuerschaltung nicht auf einen IGBT beziehungsweise die Verwendung eines IGBT beschränkt. Es ist vielmehr mit der erfindungsgemäßen Ansteuerungsschaltung auch möglich, weitere, andersartige Leistungshalbleiterbauelemente zu betrieben. Beispeilhaft sind an dieser Stelle Feldeffekttransistoren (FET) jeglicher Bauart, Bipolartransistoren, und Thyristoren erwähnt.

Gemäß einer weiteren vorteilhaften Ausführungsform der vorliegenden Ansteuerschaltung sind Betriebsgrößen wie zum Beispiel Kühlkörpertemperaturen und/oder andere Betriebsgrößen mit verhältnismäßig geringen zeitlichen Änderungen dann übertragbar, wenn Betriebsgrößen mit verhältnismäßig großen zeitlichen Änderungen nicht erfasst beziehungsweise übertragen werden oder nicht erfassbar sind.

Besonders vorteilhaft ist die Messvorrichtung der erfindungsgemäßen Ansteuerschaltung zur Erfassung von Spannungen oder Strömen oder Temperaturen vorgesehen. Dadurch ist es möglich, sämtliche für einen sicheren Betrieb des Leistungshalbleiterbauelements und eines zugehörigen Stromrichters erforderlichen Betriebsgrößen direkt in der Ansteuerschaltung zu erfassen, ohne separate Messeinrichtungen vorzusehen, die unter anderem eine eigene Hilfsenergieversorgung mit dem entsprechenden hohen Isolationsaufwand erfordern würden.

Eine weitere sehr vorteilhafte Ausführungsform der vorliegenden Erfindung ist dadurch gekennzeichnet, dass Status- und/oder Fehlersignale an die Steuerung übertragbar sind.

Nachfolgend wird die erfindungsgemäße Ansteuerschaltung sowie das erfindungsgemäße Betriebsverfahren für eine Ansteuerschaltung unter Bezugnahme auf die Zeichnungen erklärt, wobei
- Figur 1: schematisch eine Phase eines Wechselrichters zeigt, bei dem das erfindungsgemäße Betriebsverfahren anwendbar ist,
- Figur 2: eine erfindungsgemäße Ansteuerschaltung zeigt,
- Figur 3: eine Detailansicht einer weiteren Ausführungsform der Erfindung zeigt, und
- Figur 4: ein Impulsdiagramm zu dem erfindungsgemäßen Betriebsverfahren zeigt.

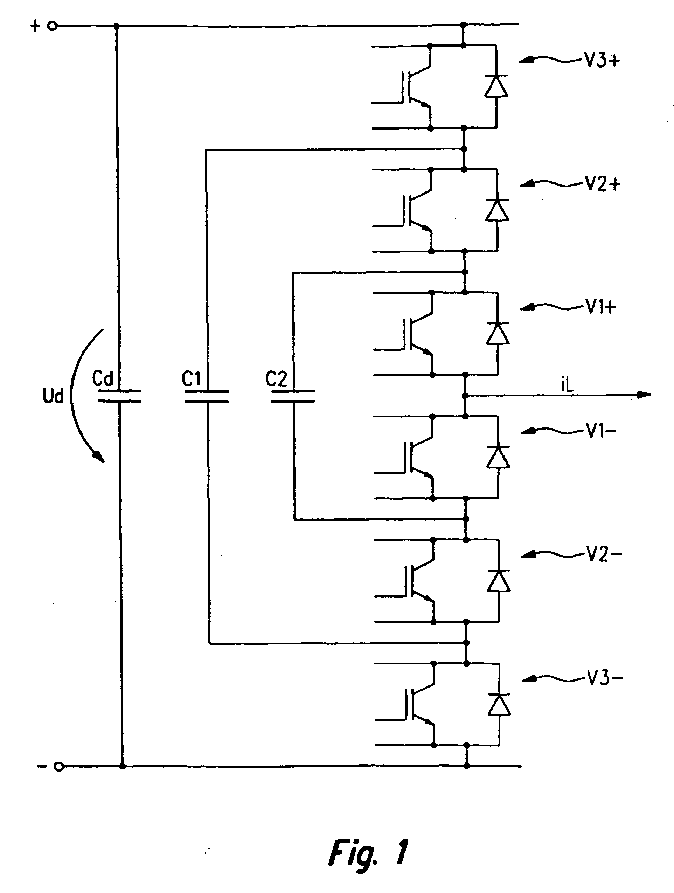

Die in Figur 1 abgebildete Schaltung, die eine Phase eines sogenannten Vierlevelwechselrichters darstellt, weist insgesamt sechs als IGBT (insulated gate bipolar transistor) ausgebildete Leistungshalbleiterbauelemente V1+, V2+, V3+, V1-,V2- ,V3- auf, die in Reihe geschaltet sind. An dieser Reihenschaltung liegt eine Zwischenkreisspannung Ud an. Ferner weist die Schaltung nach Figur 1 Kondensatoren C1, C2, Cd auf, die jeweils parallel geschaltet sind zu einer Reihenschaltung bestehend aus mehreren IGBTs.

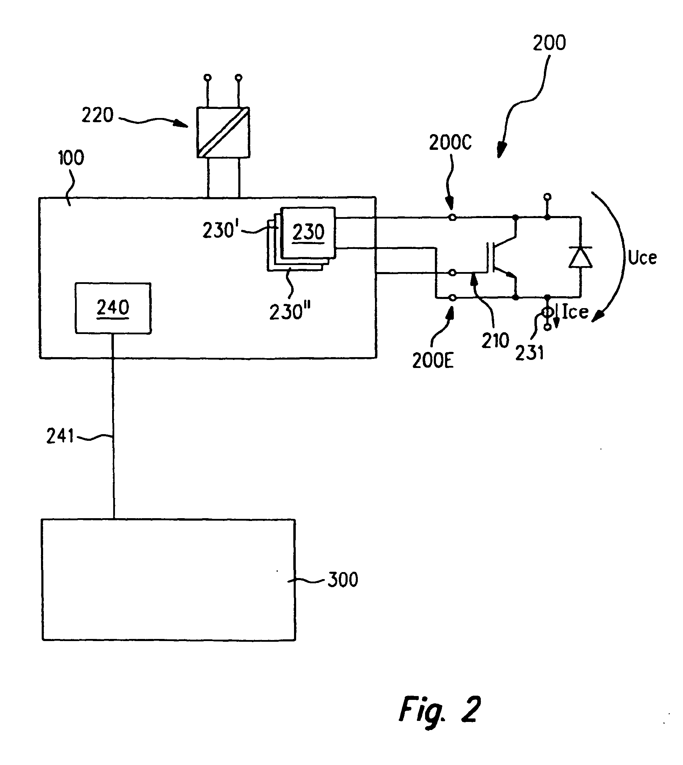

Mindestens einer der in Figur 1 abgebildeten IGBTs weist eine Ansteuerschaltung 100 auf, wie sie in Figur 2 dargestellt ist, und alle in Fig. 1 abgebildeten IGBTs besitzen denselben Aufbau wie der gemäß Figur 2 an die Ansteuerschaltung 100 angeschlossene IGBT 200.

Wie aus Figur 2 ersichtlich ist, weist die Ansteuerschaltung 100 eine Messvorrichtung 230 auf, die mit einem Kollektoranschluss 200C und einem Emitteranschluss 200E des IGBT 200 verbunden ist. Damit ist es möglich, eine über der Kollektor-Emitter-Strecke des IGBT 200 abfallende Kollektor-Emitter-Spannung Uce zu erfassen. Ferner weist die Ansteuerungsschaltung 100 eine weitere Messvorrichtung 230' auf, die über nicht näher dargestellte Anschlussleitungen mit einem Stromsensor 231 verbunden ist, der in der Kollektor-Emitter-Strecke des IGBT 200 angeordnet ist und somit eine Erfassung eines Kollektor-Emitter-Stroms Ice ermöglicht.

Darüber hinaus weist die erfindungsgemäße Ansteuerschaltung 100 noch andere Messvorrichtungen 230" auf, die beispielsweise mit einem nicht dargestellten Temperatursensor verbunden sind, um eine Kühlkörpertemperatur des IGBT 200 zu erfassen. Alternativ hierzu können in der Ansteuerschaltung 100 weitere Messvorrichtungen vorgesehen sein, die zur Messung von Spannungen, Strömen oder sonstigen Betriebsgrößen des IGBT 200 oder auch weiterer, vorzugsweise mit dem IGBT 200 verbundener Bauelemente dienen können. Sehr vorteilhaft können diese weiteren Messvorrichtungen auch zur Messung an Bauelementen genutzt werden, die vorzugsweise mit einem elektrischen Potential des Emitteranschlusses 200E bzw. des Gateanschlusses/Steuereingangs 210 verbunden sind.

Beispielsweise können in einer Ansteuerschaltung 100 z.B. des IGBT V1+ aus Fig. 1 Messvorrichtungen 230, 230' dazu vorgesehen sein, die Betriebsgrößen Uce, Ice sowie Kühlkörpertemperaturen des IGBT V1+ zu erfassen. Darüberhinaus sind in der Ansteuerschaltung 100 des IGBT V1+ weitere Messvorrichtungen vorgesehen, die zur Erfassung von Spannungen und/oder Strömen und/oder Temperaturen und/oder sonstigen Betriebsgrößen der benachbarten Bauelemente, d.h. der IGBTs V2+, V1- oder auch des Kondensators C1 dienen.

Insgesamt ist daher mit der Ansteuerschaltung 100 eine Vielzahl von Betriebsparametern des IGBT 200 beziehungsweise von Schaltungen, in denen der IGBT 200 eingesetzt beziehungsweise verwendet wird, erfassbar. Dabei ist die Integration der Messvorrichtungen 230, 230', 230 " in die Ansteuerschaltung 100 ganz besonders vorteilhaft, da diese Messvorrichtungen gemeinsam mit weiteren Komponenten der Ansteuerschaltung 100 von einer einzigen Hilfsenergieversorgung 220 mit elektrischer Energie versorgt werden. Ein von herkömmlichen, separaten Messvorrichtungen bekannter Aufwand insbesondere für die Bereitstellung weiterer Hilfsenergieversorgungen ist mit der vorliegenden Ansteuerschaltung 100 nicht erforderlich.

Besonders vorteilhaft weist die Ansteuerschaltung 100 eine Übertragungsvorrichtung 240 auf, mit der die von den Messvorrichtungen 230, 230', 230" erfassten Betriebsgrößen über eine potentialgetrennte Schnittstelle 241 wie z.B. eine Lichtleiterverbindung an eine Steuerung 300 übertragen werden können. Die Übertragung der erfassten Betriebsgrößen erfolgt priorisiert, d.h. dass Betriebsgrößen mit einer größeren zeitlichen Änderung bevorzugt übertragen werden, und dass Betriebsgrößen mit einer geringeren zeitlichen Änderung weniger häufig beziehungsweise nur dann übertragen werden, wenn die Schnittstelle 241 nicht anderweitig verwendet wird.

Insbesondere wird die Kollektor-Emitter-Spannung Uce des IGBT 200 bevorzugt dann erfasst und übertragen, wenn der IGBT 200 sich in seinem Sperrzustand befindet. Umgekehrt wird der Kollektor-Emitter-Strom Ice durch den IGBT 200 bevorzugt dann übertragen, wenn der IGBT 200 sich in einem leitenden Zustand, d.h. einem Einschaltzustand, befindet.

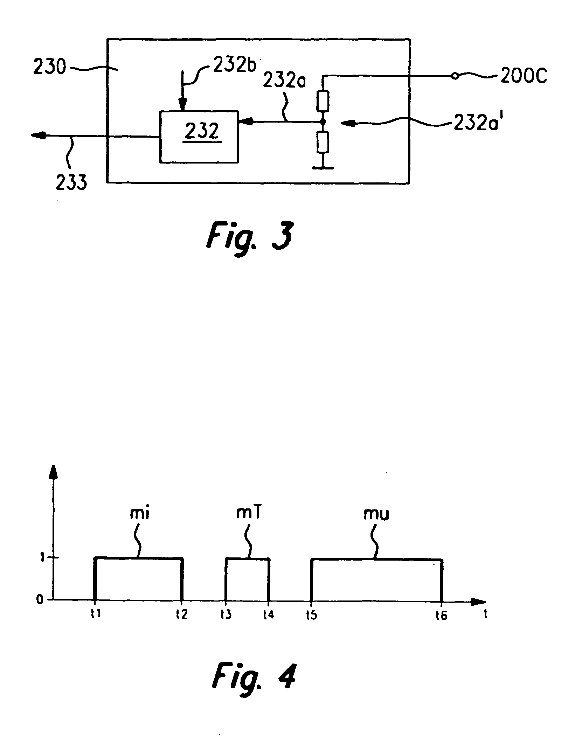

Eine derartige priorisierte Erfassung und Übertragung der Betriebsgrößen ist anhand des Impulsdiagramms in Fig. 4 näher erläutert. Das Impulsdiagramm zeigt den zeitlichen Verlauf dreier Logikvariablen mi, mT, mu, die jeweils nur die Werte null und eins annehmen können. Sobald eine Logikvariable eins ist, wird bei der Ansteuerschaltung 100 eine Erfassung derjenigen Betriebsgröße des IGBT 200 durchgeführt, die der jeweiligen Logikvariable entspricht. An die Erfassung schließt sich direkt eine Übertragung der erfassten Betriebsgröße über die Schnittstelle 241 zur Steuerung 300 an.

Wie aus Fig. 4 ersichtlich, ist zum Zeitpunkt t = 0 zunächst keine der Logikvariablen mi, mT, mu von Null verschieden, so dass keine Betriebsgröße erfasst wird. Sobald zum Zeitpunkt t = t1 die Logikvariable mi, die dem Kollektor-Emitter-Strom Ice des IGBTs 200 zugeordnet ist, eins wird, wird der Kollektor-Emitter-Strom Ice mittels einer Messvorrichtung 230' (Fig. 2) der Ansteuerschaltung 100 erfasst und anschließend an die Steuerung 300 übertragen. Danach nimmt die Logikvariable mi bei t = t2 erneut den Wert null an.

Entsprechend wird während eines Zeitintervalls [t3, t4] unter Steuerung durch die Logikvariable mT eine Erfassung und Übertragung der Kühlkörpertemperatur des IGBTs 200 durchgeführt. Danach wird in dem Zeitintervall [t5, t6] die Kollektor-Emitter-Spannung Uce gemäß der Logikvariablen mu erfasst und übertragen.

Die vorstehend beschriebene Reihenfolge der Erfassung von Betriebsgrößen des IGBTs 200 ergibt sich beispielsweise aus einem Übergang des IGBT 200 von einem leitenden Zustand, also dem Einschaltzustand, zu einem Sperrzustand. Während des Einschaltzustandes, d.h. von t1 bis t2 ist eine Erfassung des Kollektor-Emitter-Stroms Ice von besonderem Interesse, wohingegen während eines Umschaltens des IGBT 200 in den Sperrzustand zwischen t = t2 und t = t5 sowohl der Kollektor-Emitter-Strom Ice als auch die Kollektor-Emitter-Spannung Uce nicht interessieren. In dem Intervall [t3, t4] wird daher als weniger bedeutende Größe die Kühlkörpertemperatur des IGBTs 200 erfasst und übertragen.

Obwohl die Erfassung der Betriebsgrößen üblicherweise kontinuierlich bzw. periodisch erfolgt, ist auch eine unregelmäßige Erfassung der Betriebsgrößen denkbar. In solchen Fällen finden beispielsweise mehrere prinzipiell der Fig. 4 entsprechende Übertragungen statt zwischen zwei Zeitpunkten, zu denen bspw. eine Betriebsgröße messtechnisch erfasst wird.

Insbesondere bei Verwendung einer auch bei herkömmlichen Systemen vorhandenen Schnittstelle, über die erfindungsgemäß zusätzlich die oben genannten Betriebsgrößen übertragen werden, ist eine geordnete Übertragung gem. Fig. 4 vorteilhaft, um auf der Schnittstelle vorhandene freie Kommunikationskanäle optimal nutzen zu können.

Zusätzlich zu der priorisierten Übertragung ist eine Kodierung von erfassten Betriebsgrößen möglich. Beispielsweise können die erfassten Betriebsgrößen vor einer Übertragung einer Entropiekodierung unterzogen werden, um eine zu übertragende Datenmenge zu reduzieren. Ergänzend oder alternativ hierzu ist es auch möglich, die zu übertragenden Daten mit Redundanz zu versehen, um eine Fehleranfälligkeit der Datenübertragung zu verringern.

Neben den erfassten Betriebsgrößen werden über die Schnittstelle 241 auch Status- und/oder Fehlersignale an die Steuerung 300 übertragen. Diese Signale können gemäß Fig. 4 beispielsweise in freien Zeitschlitzen [0, t1], [t2, t3] oder [t4, t5] übertragen werden, ohne die Übertragung der Betriebsgrößen zu beeinträchtigen.

Die Schnittstelle 241 kann gemäß einer weiteren Ausführungsform der erfindungsgemäßen Ansteuerschaltung 100 auch dazu vorgesehen sein, Betriebsgrößen und/oder Status- bzw. Fehlersignale mit weiteren Ansteuerschaltungen (nicht gezeigt) und/oder weiteren Steuerungen auszutauschen.

Es ist auch möglich, die vorstehend beschriebene Priorisierung abhängig von einem Betriebszustand des IGBTs 200 und/oder von Umgebungsbedingungen wie z.B. einer Raum- bzw. Umgebungstemperatur durchzuführen und z.B. bei besonders hohen Umgebungstemperaturen häufiger die interessierenden bzw. kritischen Betriebsgrößen zu übertragen.

Figur 3 zeigt in einer Detailansicht eine Messvorrichtung 230 gemäß einer weiteren Ausführungsform der Erfindung. Die Messvorrichtung 230 weist ein als Spannungsteiler ausgebildetes Messglied 232a' auf, das in der in Fig. 3 dargestellten Weise mit dem Kollektoranschluss 200C, vgl. auch Fig. 2, verbunden ist.

Ein Ausgangssignal 232a des Spannungsteilers 232a' wird einem Analog-/Digital Wandler 232 zugeführt, der das Ausgangssignal 232a digitalisiert. Das digitalisierte Ausgangssignal 233 wird der Übertragungseinrichtung 240 (Fig. 2) zur Übertragung an die Steuerung 300 zugeführt.

Ein Signal 232b, das stellvertretend für weitere, von anderen, nicht abgebildeten Messgliedern herrührende Signale steht, wird ebenfalls dem Analog-/Digital Wandler 232 zugeführt. Die dem Analog-/Digital Wandler 232 zugeführten Signale werden in Anlehnung an die in Fig. 4 dargestellten Logikvariablen priorisiert in dem Analog-/Digital Wandler 232 erfasst und zur Übertragungsvorrichtung 240 weitergeleitet. Beispielsweise kann der Analog-/Digital Wandler 232 hierzu mehrere, gemultiplexte Eingänge aufweisen, wobei das jeweils zu digitalisierende Signal bzw. der diesem Signal zugeordnete Eingang in Abhängigkeit der Logikvariablen mi, mT, mu ausgewählt wird.

Besonders vorteilhaft ist eine Erfassung von Betriebsgrößen, die sich auf emitternahen Potentialen befinden, d.h. von solchen Betriebsgrößen, deren Potentialdifferenz zu einem Emitterpotential des IGBTs 200 einen vorgebbaren Grenzwert nicht überschreitet. In diesem Fall ist nämliche eine einfache Erfassung der Betriebsgrößen ohne besondere Isolationsmaßnahmen möglich.

Generell vereinfacht sich der Aufbau insbesondere von Mittelspannungsschaltanlagen durch den Einsatz der erfindungsgemäßen Ansteuerschaltung 100 deutlich, weil durch die Integration der Messvorrichtung(en) in die Ansteuerschaltung bei bisherigen Systemen erforderliche Hilfsenergieversorgungen eingespart werden können.

Die erfindungsgemäß erfassten Betriebsgrößen an den jeweiligen IGBTs erlauben bei einer Schaltung nach Fig. 1 z.B. die Ermittlung der Spannungen an den Kondensatoren C1, C2, Cd und z.B. des Laststroms iL. Analog hierzu kann auch bei anderen Schaltungen die Spannung an sog. floating capacitors ermittelt werden, d.h. an Kondensatoren, deren beide Pole an zeitlich veränderlichen elektrischen Potentialen liegen.

Bei einem sog. Zweilevelstromrichter (nicht gezeigt) mit zwei komplementär schaltenden IGBTs kann mithilfe der erfindungsgemäßen Ansteuerschaltung 100 aus den im Sperrzustand des jeweiligen IGBTs erfassten Kollektor-Emitter-Spannungen die Zwischenkreisspannung des Zweilevelstromrichters ermittelt werden.

Ganz besonders vorteilhaft ist der Einsatz der vorliegenden Erfindung bei Multilevelstromrichtern, um zahlreiche Betriebsgrößen der darin enthaltenen Leistungshalbleiterbauelemente zu erfassen. Eine Kenntnis dieser auch als internen Betriebsgrößen bezeichneten Größen ermöglicht eine bessere Ausnutzung des Multilevelstromrichters, weil kritische Zustände einzelner Leistungshalbleiterbauelemente besser erkannt werden können und daher andererseits weniger große Toleranzbänder hinsichtlich mancher Betriebsparameter gewählt werden können.

Weiterhin vorteilhaft sind die durch eine Vielzahl erfasster Betriebsgrößen erweiterten Diagnosemöglichkeiten.

## Patentansprüche

1. Ansteuerschaltung (100) für ein Leistungshalbleiterbauelement (200) mit einem Steuereingang (210), mit mindestens einer Messvorrichtung (230) und einer Übertragungsvorrichtung (240), die in die Ansteuerschaltung (100) integriert sind, und mit einer Hilfsenergieversorgung (220) zur Versorgung der Ansteuerschaltung (100) sowie zur Energieversorgung der Messvorrichtung (230) und der Übertragungsvorrichtung (240), **dadurch gekennzeichnet, dass** die Messvorrichtung (230) zur Erfassung einer Spannung oder eines Stroms oder einer Temperatur des Leistungshalbleiterbauelements (200) vorgesehen ist, und dass die Übertragungsvorrichtung (240) zur Übertragung der erfassten Spannung oder des erfassten Stroms oder der erfassten Temperatur an eine extern der Ansteuerschaltung (100) angeordnete Steuerung (300) vorgesehen ist.

2. Ansteuerschaltung (100) nach Anspruch 1, wobei die Übertragungsvorrichtung (240) eine, vorzugsweise potentialgetrennte, Schnittstelle (241) zu der Steuerung (300) aufweist.

3. Ansteuerschaltung (100) nach Anspruch 1 oder 2, wobei die Übertragungsvorrichtung (240) eine bereits vorhandene Schnittstelle zu der Steuerung (300) verwendet.

4. Ansteuerschaltung (100) nach einem der Ansprüche 1 bis 3, wobei die erfasste Spannung oder der erfasste Strom oder die erfasste Temperatur priorisiert übertragbar ist.

5. Ansteuerschaltung (100) nach einem der Ansprüche 1 bis 4, wobei bei einer Ausbildung des Leistungshalbleiterbauelements (200) als IGBT (insulated gate bipolar transistor) eine Kollektor-Emitter-Spannung (Uce) dann übertragbar ist, wenn sich der IGBT (200) in einem vorzugsweise stationären, Sperrzustand befindet.

6. Ansteuerschaltung (100) nach einem der Ansprüche 1 bis 5, wobei bei einer Ausbildung des Leistungshalbleiterbauelements (200) als IGBT (insulated gate bipolar transistor) ein Kollektor-Emitter-Strom (Ice) dann übertragbar ist, wenn sich der IGBT (200) in einem, vorzugsweise stationären, Einschaltzustand befindet.

7. Ansteuerschaltung (100) nach einem der Ansprüche 1 bis 6, wobei eine Kühltemperatur mit einer verhältnismäßig geringen zeitlichen Änderung dann übertragbar ist, wenn Betriebsgrößen mit verhältnismäßig großen zeitlichen Änderungen nicht übertragen werden.

8. Ansteuerschaltung (100) nach einem der Ansprüche 1 bis 7, wobei die erfasste Spannung oder der erfasste Strom oder die erfasste Temperatur kodiert übertragbar ist.

9. Ansteuerschaltung (100) nach einem der Ansprüche 1 bis 8, wobei Status- und/oder Fehlersignale an die Steuerung (300) übertragbar sind.

10. Betriebsverfahren für eine Ansteuerschaltung (100) eines Leistungshalbleiterbauelements (200), wobei das Leistungshalbleiterbauelement (200) einen Steuereingang (210) aufweist, wobei die Ansteuerschaltung (100) mindestens eine Messvorrichtung (230) und eine Übertragungsvorrichtung (240) aufweist, die in die Ansteuerschaltung (100) integriert sind, und wobei die Ansteuerschaltung (100) mit einer Hilfsenergieversorgung (220) zur Versorgung der Ansteuerschaltung (100) sowie zur Energieversorgung der Messvorrichtung (230) und der Übertragungsvorrichtung (240) versehen ist, **dadurch gekennzeichnet, dass** von der Messvorrichtung (230) eine Spannung oder eine Strom oder eine Temperatur des Leistungshalbleiterbauelements (200) erfasst wird, und dass die erfasste Spannung oder der erfasste Strom oder die erfasste Temperatur von der Übertragungsvorrichtung (240) an eine extern der Ansteuerschaltung (100) angeordnete Steuerung (300) übertragen wird.

11. Verfahren nach Anspruch 10, wobei die Spannung oder der Strom oder die Temperatur priorisiert erfasst und/oder übertragen wird.

12. Verfahren nach Anspruch 11, wobei die Priorisierung der Erfassung und/oder der Übertragung in Abhängigkeit eines Betriebszustands des Leistungshalbleiterbauelements (200) durchgeführt wird.

13. Verfahren nach einem der Ansprüche 10 bis 12, wobei die erfasste Spannung oder der erfasste Strom oder die erfasste Temperatur kodiert übertragen wird.

## Claims

1. Drive circuit (100) for a power semiconductor component (200) with a control input (210), at least one measuring device (230) and a transmission device (240) which are integrated in the drive circuit (100), and with an auxiliary energy supply (220) to supply the drive circuit (100) as well as to supply energy to the measuring device (230) and the transmission device (240), **characterised in that** the measuring device (230) is provided in order to measure a voltage or a current or a temperature of the power semiconductor component (200), and that the transmission device (240) is provided in order to transmit the measured voltage or the measured current or the measured temperature to a control system (300) arranged externally to the drive circuit (100).

2. Drive circuit (100) according to claim 1, wherein the transmission device (240) possesses a, preferably galvanically isolated, interface (241) with the control system (300).

3. Drive circuit (100) according to claim 1 or 2, wherein the transmission device (240) uses an already existing interface with the control system (300).

4. Drive circuit (100) according to one of the claims 1 to 3, wherein the measured voltage or the measured current or the measured temperature can be transmitted on a prioritised basis.

5. Drive circuit (100) according to one of the claims 1 to 4, wherein, where the power semiconductor component (200) is in the form of an IGBT (insulated gate bipolar transistor), a collector emitter voltage (Uce) can be transmitted if the IGBT (200) is in a, preferably stationary, off-state.

6. Drive circuit (100) according to one of the claims 1 to 5, wherein, where the power semiconductor component (200) is in the form of an IGBT (insulated gate bipolar transistor), a collector emitter current (Ice) can be transmitted if the IGBT (200) is in a, preferably stationary, on-state.

7. Drive circuit (100) according to one of the claims 1 to 6, wherein a cooling temperature with a relatively small change over time can be transmitted if operating variables with relatively large changes over time are not transmitted.

8. Drive circuit (100) according to one of the claims 1 to 7, wherein the measured voltage or the measured current or the measured temperature can be transmitted in coded form.

9. Drive circuit (100) according to one of the claims 1 to 8, wherein status and/or error signals can be transmitted to the control system (300).

10. Operating method for a drive circuit (100) of a power semiconductor component (200), wherein the power semiconductor component (200) possesses a control input (210), wherein the drive circuit (100) possesses at least one measuring device (230) and a transmission device (240) which are integrated in the drive circuit (100), and wherein the drive circuit (100) is provided with an auxiliary energy supply (220) to supply the drive circuit (100) as well as to supply energy to the measuring device (230) and the transmission device (240), **characterised in that** a voltage or a current or a temperature of the power semiconductor component (200) is measured by the measuring device (230), and that the measured voltage or the measured current or the measured temperature is transmitted by the transmission device (240) to a control system (300) arranged externally to the drive circuit (100).

11. Method according to claim 10, wherein the voltage or the current or the temperature is measured and/or transmitted on a prioritised basis.

12. Method according to claim 11, wherein the prioritisation of the measurement and/or the transmission is dependent on an operating state of the power semiconductor component (200).

13. Method according to one of the claims 10 to 12, wherein the measured voltage or the measured current or the measured temperature is transmitted in coded form.

## Revendications

1. Circuit d'attaque (100) pour un composant semi-conducteur de puissance (200) pourvu d'une entrée de commande (210), comprenant au moins un dispositif de mesure (230) et un dispositif de transmission (240) qui sont intégrés dans le circuit d'attaque (100), et comprenant une source d'énergie auxiliaire (220) pour alimenter le circuit d'attaque (100) ainsi que pour fournir de l'énergie au dispositif de mesure (230) et au dispositif de transmission (240), **caractérisé en ce que** le dispositif de mesure (230) est prévu pour détecter une tension ou un courant ou une température du composant semi-conducteur de puissance (200) et **en ce que** le dispositif de transmission (240) est prévu pour transmettre la tension détectée ou le courant détecté ou la température détectée à une commande (300) disposée à l'extérieur du circuit d'attaque (100).

2. Circuit d'attaque (100) selon la revendication 1, dans lequel le dispositif de transmission (240) présente une interface (241), de préférence isolée galvaniquement, avec la commande (300).

3. Circuit d'attaque (100) selon la revendication 1 ou la revendication 2, dans lequel le dispositif de transmission (240) utilise une interface déjà existante avec la commande (300).

4. Circuit d'attaque (100) selon l'une des revendications 1 à 3, dans lequel la tension détectée ou le courant détecté ou la température détectée peut être transmis(e) de manière priorisée.

5. Circuit d'attaque (100) selon l'une des revendications 1 à 4, dans lequel, lorsque le composant semi-conducteur de puissance (200) est réalisé sous la forme d'un transistor IGBT (insulated gate bipolar transistor), une tension collecteur - émetteur (Uce) peut être transmise lorsque le transistor IGBT (200) se trouve dans un état bloqué, de préférence stationnaire.

6. Circuit d'attaque (100) selon l'une des revendications 1 à 5, dans lequel, lorsque le composant semi-conducteur de puissance (200) est réalisé sous la forme d'un transistor IGBT (insulated gate bipolar transistor), un courant collecteur - émetteur (Ice) peut être transmis lorsque le transistor IGBT (200) se trouve dans un état passant, de préférence stationnaire.

7. Circuit d'attaque (100) selon l'une des revendications 1 à 6, dans lequel une température de refroidissement qui varie de manière relativement minime dans le temps peut être transmise lorsqu'il n'est pas transmis de grandeurs de fonctionnement qui varient de manière relativement grande dans le temps.

8. Circuit d'attaque (100) selon l'une des revendications 1 à 7, dans lequel la tension détectée ou le courant détecté ou la température détectée peut être transmis(e) sous forme codée.

9. Circuit d'attaque (100) selon l'une des revendications 1 à 8, dans lequel des signaux d'état et/ou de défaut peuvent être transmis à la commande (300).

10. Procédé de commande d'un circuit d'attaque (100) d'un composant semi-conducteur de puissance (200), ledit composant semi-conducteur de puissance (200) étant pourvu d'une entrée de commande (210), dans lequel le circuit d'attaque (100) comprend au moins un dispositif de mesure (230) et un dispositif de transmission (240) qui sont intégrés dans le circuit d'attaque (100) et dans lequel le circuit d'attaque (100) est pourvu d'une source d'énergie auxiliaire (220) pour alimenter le circuit d'attaque (100) ainsi que pour fournir de l'énergie au dispositif de mesure (230) et au dispositif de transmission (240), **caractérisé en ce qu'**une tension ou un courant ou une température du composant semi-conducteur de puissance (200) est détecté(e) par le dispositif de mesure (230) et **en ce que** la tension détectée ou le courant détecté ou la température détectée est transmis(e) par le dispositif de transmission (240) à une commande (300) disposée à l'extérieur du circuit d'attaque (100).

11. Procédé selon la revendication 10, dans lequel la tension ou le courant ou la température est détecté(e) et/ou transmis(e) de manière priorisée.

12. Procédé selon la revendication 11, dans lequel la priorisation de la détection et/ou de la transmission se fait en fonction d'un état de fonctionnement du composant semi-conducteur de puissance (200).

13. Procédé selon l'une des revendications 10 à 12, dans lequel la tension détectée ou le courant détecté ou la température détectée est transmis(e) sous forme codée.
